(19) Europäisches Patentamt / European Patent Office / Office européen des brevets

(11) **EP 2 439 851 B1**

(12) **EUROPEAN PATENT SPECIFICATION**

(45) Date of publication and mention of the grant of the patent:
**04.01.2017 Bulletin 2017/01**

(21) Application number: **10782937.6**

(22) Date of filing: **17.05.2010**

(51) Int Cl.:
*H03M 13/11* *(2006.01)*

(86) International application number:
**PCT/CN2010/072828**

(87) International publication number:
**WO 2010/139233 (09.12.2010 Gazette 2010/49)**

(54) **ENCODING OF A SYSTEMATIC LDPC CODE USING THE CHECK MATRIX**

ENCODIERUNG EINES SYSTEMATISCHEN LDPC CODES UNTER DER VERWENDUNG DER CHECKMATRIX

CODAGE D'UN CODE SYSTÉMATIQUE DE TYPE LDPC UTILISANT LA MATRICE DE CONTRÔLE

(84) Designated Contracting States:
**AL AT BE BG CH CY CZ DE DK EE ES FI FR GB GR HR HU IE IS IT LI LT LU LV MC MK MT NL NO PL PT RO SE SI SK SM TR**

(30) Priority: **31.05.2009 CN 200910086332**

(43) Date of publication of application:
**11.04.2012 Bulletin 2012/15**

(73) Proprietor: **ZTE Corporation**
**Shenzhen, Guangdong 518057 (CN)**

(72) Inventors:
- **ZHANG, Tao**
  **Shenzhen**
  **Guangdong 518057 (CN)**
- **YOU, Yueyi**
  **Shenzhen**
  **Guangdong 518057 (CN)**
- **LI, Qiang**
  **Shenzhen**
  **Guangdong 518057 (CN)**
- **QIU, Ning**
  **Shenzhen**
  **Guangdong 518057 (CN)**
- **CAO, Nanshan**
  **Shenzhen**
  **Guangdong 518057 (CN)**
- **YAO, Yangzhong**
  **Shenzhen**
  **Guangdong 518057 (CN)**

(74) Representative: **Lavoix**
**Bayerstrasse 83**
**80335 München (DE)**

(56) References cited:
**EP-A2- 1 443 656        WO-A2-2004/047019**
**CN-A- 1 739 244         CN-A- 1 801 630**
**CN-A- 101 321 043       US-A1- 2008 222 486**
**US-B2- 7 139 959**

- **MACKAY D. J. C. ET AL: "Comparison of Constructions of Irregular Gallager Codes", IEEE TRANSACTIONS ON COMMUNICATIONS, IEEE SERVICE CENTER, PISCATAWAY, NJ. USA, vol. 47, no. 10, 1 October 1999 (1999-10-01), XP011009518, ISSN: 0090-6778**
- **T. Kirubarajan: "Computer Aided Engineering - LU Decomposition", , 2007, pages 1-5, XP055080989, Electrical and Computer Engineering Department , McMaster University, Hamilton, Canada Retrieved from the Internet: URL:http://www.ece.mcmaster.ca/~kiruba/3sk3/lecture6.pdf [retrieved on 2013-09-25]**

**Description**

## TECHNICAL FIELD

The present disclosure relates to the field of an encoding technology in a communication system, in particular to a layered encoding method and device for a Low Density Parity Check (LDPC) code.

## BACKGROUND

Validity and reliability of information transmission are two important indexes for evaluation of a communication system. In order to enhance the reliability of information transmission, a certain redundancy is usually increased when channel encoding is executed to information, to make the code word be capable of performing error detection and correction automatically; at the same time, taking validity of information transmission into consideration, higher redundancy does not mean better effect, in actual application, it is usually expected to obtain good decoding performance at the receiver through a proper encoding/decoding method under a constant redundancy.

A Low Density Parity Check (LDPC) code is a linear block code based on a sparse check matrix; some existing communication systems, such as a Digital Video Broadcasting (DVB) system, a Worldwide Interoperability for Microwave Access (WiMAX) system and a China Mobile Multimedia Broadcasting (CMMB) system, all employ the LDPC code for channel encoding.

According to the distribution of elements "1" in the check matrix H of an LDPC code, we can sort LDPC codes generated by the check matrix H into a regular code and an irregular code. If there is constant r elements "1" in each row and constant c elements "1" in each column in the matrix H, the generated LDPC code is called a (c, r) regular code; if the number of elements "1" in each row and each column in H is inconstant, the generated LDPC code is called an irregular code. According to the structure characteristics of the check matrix H itself of the LDPC code, we also can sort the LDPC codes into a Quasi Cyclic LDPC (QC-LDPC) code and an LDPC code constructed by a common matrix. If the matrix H can be seemed as a combination of a series of a zero sub-matrix, unit sub-matrix and cyclic shift matrix of the unit sub-matrix, the matrix H can be seemed as a matrix having quasi cyclic characteristics and the LDPC code generated by the matrix H is a QC-LDPC code; otherwise, the matrix H is a common sparse matrix and the LDPC code generated by the matrix H is a LDPC code constructed by a common matrix.

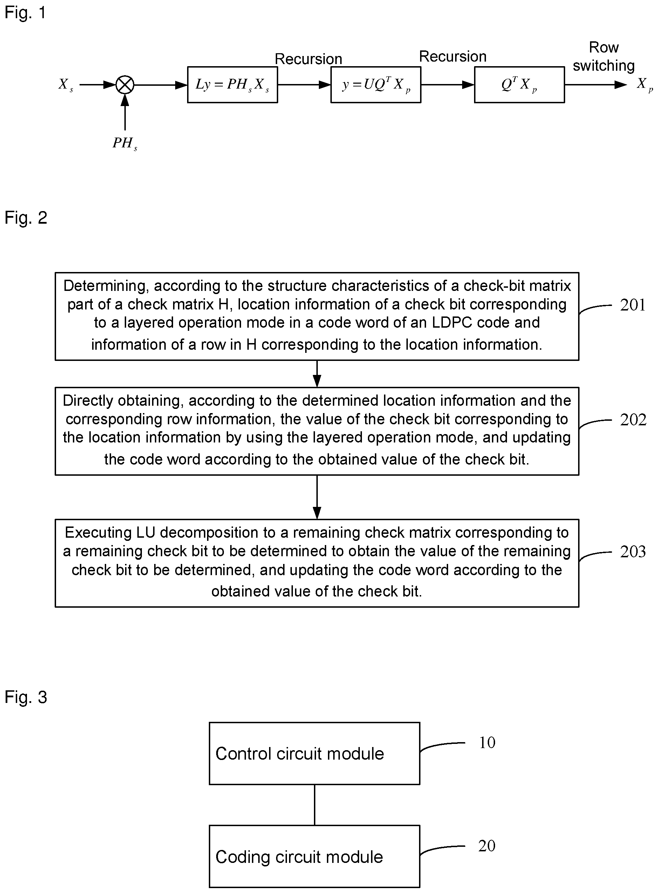

In WiMAX and DVB systems, the check matrix H of an LDPC code has quasi cyclic characteristics, but in a CMMB system, the check matrix H of the LDPC code is a common sparse matrix. For a QC-LDPC code, the encoding process can be realized simply and the check bit can be obtained by recursion operation. However, for the LDPC code constructed by the common matrix, the encoding process is relatively complicated, and the encoding process of such LDPC code can be realized by LU decomposition. L in LU decomposition represents a lower triangular matrix and U represents an upper triangular matrix, the realization process of encoding of the LDPC code by LU decomposition is shown in Fig. 1, assuming that the check matrix of the LDPC code is a MxN matrix H and the code word of the LDPC code is C, then there is $H \cdot C = 0^T$, if the code word C is the code word of a systematic code, C may be expressed as $C=[X_p^T, X_s^T]^T$ which is known to the encoding end, wherein $X_p$ represents the check bit of the code word, $X_s$ represents the information bit of the code word, the purpose of encoding is to obtain the check bit $X_p$. The check matrix H is divided into two parts, that is, $H=[H_p, H_s]$, $H_p$ represents the matrix part of the check bit, $H_s$ represents the matrix part of the information bit, in this way, the value $H_p^{-1} H_s X_s$ of $X_p$ can be obtained. As $H_p^{-1}$ has no s sparseness, it is impractical to calculate and store it. Therefore, it is usually required to execute LU decomposition to $H_p^{-1}$ to obtain the lower triangular matrix L and upper triangular matrix U, and then the check bit $X_p$ can be obtained by two times of recursion operations of L and U.

It can be seen that, although the LDPC encoding method in which LU decomposition is executed to $H_p^{-1}$ can reduce the storage amount of $H_p^{-1}$ to some extent, the memory space required for storing L and U is still relatively large; besides, in this encoding algorithm, it is required to execute two times of recursion operations to each check bit and the two times of the recursion operations can only be executed serially, as a result, the time delay for encoding is relatively long.

The prior art EP 1443656 (A2) provides a method of generating parity data based on a low-density parity check matrix and an apparatus therefore. The method of generating parity data based on a parity check matrix H having p codewords of length c, each codeword being divided in a message word of length m and parity data of length p, includes(a) reordering columns of the parity check matrix H based on elements in each column having values of 1 to generate a reordered parity check matrix H'; (b) determining a cross-point I between a diagonal line L2 of a parity matrix part Mp in the parity check matrix H' and a reordered diagonal line L1 defined by first entry of 1 in each column of the reordered parity check matrix H', and, on the basis of positions of 1's in rows above a horizontal line L3 that passes through the cross-point I to perform column permutations on the reordered parity check matrix H', generating a triangular matrix T; (c) using the triangular matrix T and the message words to obtain the parity data; and (d) using the equation $H_x=0$, where x is a codeword matrix, to obtain the rest of parity data which is not obtained in step (c).

## SUMMARY

In view of the problem above, the present disclosure aims to provide a layered encoding method and device for an LDPC code, to solve the problems that the memory space required is large and time delay for encoding is long in existing LDPC encoding methods.

In order to achieve the above purpose, the technical solution of the present disclosure is realized in the following way.

The present disclosure provides a layered encoding method for a Low Density Parity Check (LDPC) code as specified in claim 1.

The layered encoding method according to claim 1 may further comprise steps according to claims 2-5.

The present disclosure also provides a layered encoding device for an LDPC code as specified in claim 6.

The layered encoding device according to claim 6 may further comprise the encoding circuit module (20) as specified in claims 7-8.

With the layered encoding method and device for an LDPC code, the check bit in the LDPC code that can be calculated directly is directly obtained by layered operation of the check matrix, then LU decomposition is executed to the remaining check matrix to obtain the remaining check bit to be determined. In the present disclosure, under the layered operation mode, as the check bit within the same layer can be obtained by parallel operation, therefore the time delay for encoding is reduced; when LU decomposition is executed to the remaining check matrix, as the order of the matrix becomes smaller, the memory space required for storing L matrix and U matrix after decomposition is reduced; as the number of elements "1" in the L matrix and U matrix is reduced, the modulo-2 sum operations are also reduced, thus the time delay for encoding is further reduced.

## BRIEF DESCRIPTION OF THE DRAWINGS

Fig. 1 is a schematic diagram illustrating realization of encoding of an LDPC code through LU decomposition in existing technologies;
Fig. 2 is a flow chart illustrating a layered encoding method for an LDPC code in the present disclosure; and
Fig. 3 is a structural schematic diagram illustrating components of a layered encoding device for an LDPC code in the present disclosure.

## DETAILED DESCRIPTION

The technical solution of the present disclosure will be described in details below in combination with drawings and specific embodiments.

The layered encoding method for an LDPC code, as shown in Fig. 2, mainly comprises the following steps.

Step 201: determining, according to the structure characteristics of a check-bit matrix part $H_p$ of a check matrix H, location information of a check bit corresponding to a layered operation mode in an code word of an LDPC code and information of a row in H corresponding to the location information.

Before determining the location information of a check bit corresponding to a layered operation mode in a code word of an LDPC code, it is required to initialize the code word of the LDPC code first, which comprises: initializing the information bit and the check bit of the code word of the LDPC code. The number of the check bits is equal to the number of rows in the check matrix H. For example, the check bits of the code word C are all initialized to 0 to obtain a temporary code word C, the code length of C is N, the number of the check bits is M, the number of the information bits is N-M, that is, $C^T = (C_1, ..., C_N) = (0, ..., 0, X_{s1}, ..., X_{s(N-M)})$.

The step of determining location information of a check bit corresponding to a layered operation mode in a code word of an LDPC code and information of a row in H corresponding to the location information specifically comprises:

a1: determining a row containing only one element "1" in a corresponding $H_p$ in the first layer, and determining, according to the number of the column in the $H_p$ where the element "1" is, the location information of the check bit corresponding to the row in the code word of the LDPC code;

a2: determining a row containing only two elements "1" in a corresponding $H_p$ in the second layer, one of the two elements "1" is in the same column as the element "1" of the first layer; and determining, according to the number of the column in the $H_p$ where the element "1" that is not in the same column as the element "1" of the first layer is, the location information of the check bit corresponding to the row in the code word of the LDPC code;

a3: and the rest may be deduced by analogy, determining a row containing i elements "1" in a corresponding $H_p$ in the $i^{th}$ layer, i-1 elements "1" of the i elements "1" are in the same columns as the elements "1" of the first i-1 layers, wherein the value of i is an integer greater than 0; and determining, according to the number of the column in the $H_p$ where the element "1" that is not in the same column as the element "1" of the first i-1 layers is, the location information of the check bit corresponding to the row in the code word of the LDPC code.

Step 202: directly obtaining, according to the determined location information and the corresponding row information, the value of the check bit corresponding to the location information by using the layered operation mode, and updating the code word according to the obtained value of the check bit.

The step of executing modulo-2 sum operation to each layer in turn to obtain the value of the check bit corresponding to the determined location information in each layer (that is, for the first layer, first executing "AND" operation between the bit corresponding to the temporary code word C and the bit corresponding to the corresponding row in H, then executing modulo-2 sum operation, and finally executing operation by using the updated code word) specifically comprises:

for the first layer, first executing "AND" operation between the bit corresponding to the code word of the initialized LDPC code and the bit corresponding to the corresponding row in H, and then executing modulo-2 sum operation;

for the second layer, first executing "AND" operation between the bit corresponding to the updated code word in the first layer and the bit corresponding to the corresponding row in H, and then executing modulo-2 sum operation;

and the rest may be deduced by analogy, for the $i^{th}$ layer, first executing "AND" operation between the bit corresponding to the updated code word in the $(i-1)^{th}$ layer and the bit corresponding to the corresponding row in H, and then executing modulo-2 sum operation, the specific modulo-2 sum operation will be described in detail in the following embodiments.

The calculated location of the check bit in a certain row in the $i^{th}$ layer of the check matrix is the location of the check bit corresponding to the element "1" which is not in the same column as the element "1" of the first i-1 layers in the $H_p$ part corresponding to the row. Besides, when the $i^{th}$ layer corresponds to multiple rows in $H_p$, as there is no dependence among the calculations of rows within the same layer, the modulo-2 sum operations for all rows may be executed in parallel, thus the values of multiple check bits can be obtained and the code word is updated.

Wherein, the step of updating the code word according to the obtained value of the check bit is specifically as follows: covering the initial value corresponding to the location of the check bit in the code word C with the obtained value of the check bit, that is, covering the initial value corresponding to the location of the check bit in the $i^{th}$ layer in the code word C with the obtained value of the check bit in the $i^{th}$ layer through mouldo-2 sum operation. The specific code word updating operation will be described in details in the subsequent embodiments.

Step 203: executing LU decomposition to a remaining check matrix $H_t$ corresponding to a remaining check bit to be determined to obtain the value of the remaining check bit to be determined, and updating the code word according to the obtained value of the check bit.

Modulo-2 sum operation is executed between the corresponding bits of the row of the original check matrix H corresponding to $H_t$ and the code word updated in step 202 to obtain a temporary value $X_t$; according to $X_t$, the value of the remaining check bit to be determined is obtained by executing the LU decomposition and recursive calculation to $H_t$, and the code word is updated according to the obtained value of the check bit. The step of updating the code word is specifically as follows: covering the initial value corresponding to the location of the check bit in the code word C with the obtained value of the check bit.

The layered encoding method for the LDPC code will be further described in details below in combination with specific embodiments.

A check matrix with a code length of 12 and a code rate of 1/2 is assumed as:

$$H = \begin{bmatrix} 0 & 0 & 1 & 0 & 0 & 0 & 1 & 1 & 1 & 1 & 0 & 1 \\ 1 & 1 & 0 & 1 & 1 & 0 & 0 & 0 & 0 & 1 & 1 & 0 \\ 1 & 1 & 1 & 0 & 0 & 0 & 1 & 0 & 1 & 0 & 0 & 1 \\ 1 & 0 & 0 & 1 & 1 & 1 & 0 & 0 & 0 & 1 & 1 & 0 \\ 0 & 1 & 1 & 0 & 1 & 1 & 0 & 1 & 1 & 0 & 0 & 0 \\ 1 & 0 & 1 & 0 & 0 & 0 & 1 & 1 & 0 & 0 & 1 & 1 \end{bmatrix}$$

wherein the corresponding check-bit matrix part $H_p$ is:

$$H_p = \begin{bmatrix} 0 & 0 & 1 & 0 & 0 & 0 \\ 1 & 1 & 0 & 1 & 1 & 0 \\ 1 & 1 & 1 & 0 & 0 & 0 \\ 1 & 0 & 0 & 1 & 1 & 1 \\ 0 & 1 & 1 & 0 & 1 & 1 \\ 1 & 0 & 1 & 0 & 0 & 0 \end{bmatrix}$$

the information-bit matrix part $H_s$ is:

$$H_s = \begin{bmatrix} 1 & 1 & 1 & 1 & 0 & 1 \\ 0 & 0 & 0 & 1 & 1 & 0 \\ 1 & 0 & 1 & 0 & 0 & 1 \\ 0 & 0 & 0 & 1 & 1 & 0 \\ 0 & 1 & 1 & 0 & 0 & 0 \\ 1 & 1 & 0 & 0 & 1 & 1 \end{bmatrix}$$

the information bit of the code word C is initialized to $X_s=[0,1,0,1,0,1]$, the check bits of the code word C are all initialized to 0, thus a code word C consist of the information bit and the check bit is $C=[0,0,0,0,0,0,0,1,0,1,0,1]^T$.

The specific process of the layered operation is as follows:

A: from the structure characteristics of H, it can be known that there is a row containing only one element "1" in a corresponding $H_p$ in the first layer, therefore it can be determined that the first check bit that can be obtained directly is $X_{p3}$, the check formula of the first check bit corresponds to the first row of H; it can be directly obtained $x_{p3} = x_{s1} \oplus x_{s2} \oplus x_{s3} \oplus x_{s4} \oplus x_{s6} = 1$ through modulo-2 sum operation, wherein "$\oplus$" represents modulo-2 sum operation, according to the value of $X_{p3}$, the code word is updated to $C=[0,0,1,0,0,0,0,1,0,1,0,1]^T$;

B: there is a row containing only two elements "1" in a corresponding $H_p$ in the second layer, one of the two elements "1" is in the same column as the element "1" of the first layer, thus it can be determined that the second check bit that can be directly obtained is $X_{p1}$, the check formula of the second check bit corresponds to the sixth row of H; it can be directly obtained $X_{p1} = X_{s1} \oplus X_{s2} \oplus X_{s5} \oplus X_{s6} \oplus X_{p3} = 1$ through modulo-2 sum operation, according to the value of $X_{p1}$, the code word is updated to $C=[1,0,1,0,0,0,0,1,0,1,0,1]^T$;

C: there is a row containing only three elements "1" in a corresponding $H_p$ in the third layer, two of the three elements "1" are in the same columns as the elements "1" of the second layer; thus it can be determined that the third check bit that can be directly obtained is $X_{p2}$, the check formula of the third check bit corresponds to the third row of H; it can be directly obtained through modulo-2 sum operation, $x_{p2} = x_{s1} \oplus x_{s3} \oplus x_{s6} \oplus x_{p1} \oplus x_{p3} = 1$ according to the

value of $X_{p2}$, the code word is updated to C=[1,1,1,0,0,0,0,1,0,1,0,1]$^T$.

Then, after the first, third and sixth rows and the first, second and third columns in the matrix are removed, the remaining matrix $H_t$ is as follows: $H_t = \begin{bmatrix} 1 & 1 & 0 \\ 1 & 1 & 1 \\ 0 & 1 & 1 \end{bmatrix}$; modulo-2 sum operation is executed between corresponding bits of the rows of the original check matrix H corresponding to the $H_t$ and C=[1,1,1,0,0,0,0,1,0,1,0,1]$^T$ to obtain a temporary value $X_t$, that is, $X_t = \begin{bmatrix} H(2,:) \\ H(4,:) \\ H(5,:) \end{bmatrix} \cdot C = \begin{bmatrix} 1 \\ 0 \\ 1 \end{bmatrix}$, wherein the rows corresponding to $H_t$ are H(2,:), H(4,:) and H(5,:), H(2,:) represents the second row of the matrix H, H(4,:) represents the fourth row of the matrix H, and H(5,:) represents the fifth row of the matrix H.

Then, according to $H_tX_pX_t$, $H_t \cdot \begin{bmatrix} x_{p4} \\ x_{p5} \\ x_{p6} \end{bmatrix} = \begin{bmatrix} 1 \\ 0 \\ 1 \end{bmatrix}$ is obtained; LU decomposition is executed to $H_t$, that is, $PH_t$=LU, wherein L represents a lower triangular matrix, U represents an upper triangular matrix, and $P = \begin{bmatrix} 1 & 0 & 0 \\ 0 & 0 & 1 \\ 0 & 1 & 0 \end{bmatrix}$ represents a row switching matrix; as the row switching matrix meets P=P$^{-1}$, therefore $H_tXp=X_t$ can be represented as $LUX_p=PX_t$, that is, $\begin{bmatrix} 1 & 0 & 0 \\ 0 & 1 & 0 \\ 1 & 0 & 1 \end{bmatrix} \cdot \begin{bmatrix} 1 & 1 & 0 \\ 0 & 1 & 1 \\ 0 & 0 & 1 \end{bmatrix} \cdot \begin{bmatrix} x_{p4} \\ x_{p5} \\ x_{p6} \end{bmatrix} = \begin{bmatrix} 1 & 0 & 0 \\ 0 & 0 & 1 \\ 0 & 1 & 0 \end{bmatrix} \cdot \begin{bmatrix} 1 \\ 0 \\ 1 \end{bmatrix} = \begin{bmatrix} 1 \\ 1 \\ 0 \end{bmatrix}$, wherein L matrix and U matrix respectively are: $L = \begin{bmatrix} 1 & 0 & 0 \\ 0 & 1 & 0 \\ 1 & 0 & 1 \end{bmatrix}$ and $U = \begin{bmatrix} 1 & 1 & 0 \\ 0 & 1 & 1 \\ 0 & 0 & 1 \end{bmatrix}$. $(X_{p4}, X_{p5}, X_{p6})^T=(1,0,1)^T$ can be obtained through the recursion operation of L matrix and U matrix, thus the finally updated code word C=[1,1,1,1,0,1,0,1,0,1,0,1 ]$^T$ is obtained.

In the above embodiment, each layer under the layered operation mode only corresponds to a single row in $H_p$, however, in the event that the i$^{th}$ layer corresponds to multiple rows in $H_p$, as there is no dependency among the calculations of rows within the same layer, therefore the modulo-2 sum operations for all rows may be executed in parallel, thus the values of multiple check bits can be obtained and the code word is updated. For example, in the first layer of the check matrix H, there are two rows containing only one element "1" in the corresponding $H_p$: [000100101010] and [010000101010], and the two rows respectively correspond to the fourth bit and the second bit of the check bits in the code word C, so modulo-2 sum operations for the fourth bit and the second bit can be executed in parallel without orders, the calculated values of the check bits can be respectively used for updating the values of the fourth bit and the second bit of the check bits in the code word C.

In order to realize the layered encoding method for an LDPC code, the present disclosure also provides a layered encoding device for an LDPC code, as shown in Fig. 3, the device comprises: a control circuit module 10 and an encoding circuit module 20.

Wherein, the control circuit module 10 is arranged to determine, according to the structure characteristics of a check-bit matrix part $H_p$ of a check matrix H, location information of a check bit corresponding to a layered operation mode in a code word of an LDPC code and information of a row in H corresponding to the location information, and provide the encoding circuit module 20 with the determined location information and the corresponding row information; and is further arranged to control the encoding circuit module 20 to execute handover between the layered operation mode and an LU decomposition mode.

The encoding circuit module 20 is arranged to obtain, according to the location information and the corresponding row information provided by the control circuit module 10, the value of the check bit corresponding to the location information by using the layered operation mode; execute LU decomposition to a remaining check matrix $H_t$ corresponding to a remaining check bit to be determined to obtain the value of the remaining check bit to be determined; and update the code word according to the obtained value of the check bit.

It should be noted that the encoding circuit module 20 obtains the value of the check bit respectively through the modulo-2 sum operations under the layered operation mode and the LU decomposition mode; under the layered operation mode, when the same layer corresponds to multiple rows in $H_p$, modulo-2 sum operation can be executed in parallel for all rows.

The above descriptions are only preferred embodiments of the present disclosure and not to limit the protection scope of the present disclosure.

**Claims**

1. A layered encoding method for a Low Density Parity Check, LDPC, code,
   wherein the LDPC code is systematic and a check matrix H of the LDPC code is divided into a check-bit matrix part $H_p$ and an information-bit matrix part $H_s$,
   the method comprises:

   initializing a code word of the LDPC code, which includes steps of initializing information bits and check bits of the code word of the LDPC code;
   the method further comprising layered operation mode steps including:

   a: determining (S201), according to structure characteristics of the check-bit matrix part $H_p$ of the check matrix H, location information of the check bits in the code word of the LDPC code and row information in the check matrix H corresponding to the location information, wherein according to the structure characteristics of the check-bit matrix part $H_p$, the check matrix H comprises i layers with i > 0, each layer comprises at least one row of the check matrix H, each row of the first layer containing only one element "1" in the check-bit matrix part $H_p$ and each row of the $i^{th}$ layer with i > 1 containing only i elements "1" in the check-bit matrix part $H_p$ where i-1 elements "1" of said i elements "1" are in the same columns as the elements "1" in the first i-1 layers;
   b: obtaining (S202), according to the determined location information and the corresponding row information, values of the check bits corresponding to the location information, and updating the code word according to the obtained values of the check bits; and
   the method further comprising LU decomposition mode steps including:

   c: executing (S203) LU decomposition to a matrix $H_t$ corresponding to remaining check bits for which no value has been obtained during the layered operation mode steps to obtain values of the remaining check bits, and updating the code word according to the obtained values of the remaining check bits;
   the step a specifically comprises:

   a1: determining a row in the first layer, and determining, according to the column where the element "1" is located in the check-bit matrix parts $H_p$, location information of the corresponding check bit of said row in the first layer in the code word of the LDPC code;
   a2: determining a row in the second layer, one of the two elements "1" is in the same column as the element "1" of said determined row in the first layer; and determining, according to the column where the element "1" that is not in the same column as the element "1" of said determined row in the first layer is located in the check-bit matrix part $H_p$, the location information of the corresponding check bit of said row in the second layer in the code word of the LDPC code;
   a3: determining a row in the $i^{th}$ layer, i-1 elements "1" of the i elements "1" are in the same columns as the elements "1" of the first i-1 layers, wherein the value of i is an integer greater than 0; and determining, according to the column where the element "1" that is not in the same columns as the elements "1" of the first i-1 layers is located in the check-bit matrix part $H_p$, the location information of the corresponding check bit of said row in the $i^{th}$ layer in the code word of the LDPC code; wherein the step of updating the code word according to the obtained values of the check bits of step b is specifically as follows:

covering the initial values corresponding to the locations of the corresponding check bits of said rows in the first i layers in the code word with the values of the check bits obtained according to the determined location information and the corresponding row information of said rows in the first i layers; and

wherein the matrix $H_t$ is obtained from the check-bit matrix part $H_p$ by removing the rows determined during the layered operation mode steps and the columns containing the element "1" within the rows determined during the layered operation mode steps

2. The layered encoding method for the LDPC code according to claim 1, wherein the step b of obtaining the values of the check bits corresponding to the location information is specifically as follows: executing modulo-2 sum operation to each layer in turn to obtain the value of the check bit corresponding to the determined location information in each layer.

3. The layered encoding method for the LDPC code according to claim 2, wherein the step of executing modulo-2 sum operation to each layer in turn to obtain the value of the check bit corresponding to the determined location information in each layer is specifically as follows:

for the first layer, first executing "AND" operation between a bit corresponding to the initialized LDPC code word and a bit corresponding to a corresponding row in the check matrix H, and then executing modulo-2 sum operation;

for the second layer, first executing "AND" operation between a bit corresponding to the updated code word in the first layer and a bit corresponding to a corresponding row in the check matrix H, and then executing modulo-2 sum operation;

and the rest may be deduced by analogy, for the $i^{th}$ layer, first executing "AND" operation between a bit corresponding to the updated code word in the $(i-1)^{th}$ layer and a bit corresponding to a corresponding row in the check matrix H, and then executing modulo-2 sum operation.

4. The layered encoding method for the LDPC code according to claim 3, further comprising: when the $i^{th}$ layer corresponds to multiple rows in the check-bit matrix part $H_p$, modulo-2 sum operations to all rows being executed in parallel.

5. The layered encoding method for the LDPC code according to claim 4, wherein step c specifically comprises: executing modulo-2 sum operation between corresponding bits of a row of the check matrix H corresponding to the matrix $H_t$ and the code word updated in step b, to obtain a temporary value $X_t$; and obtaining, according to the temporary value $X_t$, the value of the remaining check bits to be determined by executing the LU decomposition and recursive operation to the matrix $H_t$.

6. A layered encoding device for an LDPC code, wherein the LDPC code is systematic and a check matrix H of the LDPC code is divided into a check-bit matrix part $H_p$ and an information-bit matrix part $H_s$, comprising: a control circuit module (10) and an encoding circuit module (20),

the control circuit module (10) is arranged to initialize a code word of the LDPC code, which includes steps of initializing information bits and check bits of the code word of the LDPC code; and to perform layered operation mode steps which include steps of determining, according to structure characteristics of the check-bit matrix part $H_p$ of the check matrix H, location information of the check bits in the code word of the LDPC code and row information in the check matrix H corresponding to the location information, and providing the encoding circuit module (20) with the determined location information and the corresponding row information, wherein according to the structure characteristics of the check-bit matrix part $H_p$, the check matrix H comprises i layers with i > 0, each layer comprises at least one row of the check matrix H, each row of the first layer containing only one element "1" in the check-bit matrix part $H_p$ and each row of the $i^{th}$ layer with i > 1 containing only i elements "1" in the check-bit matrix part $H_p$ where i-1 elements "1" of said i elements "1" are in the same columns as the elements "1" in the first i-1 layers;

the control circuit module (10) is further arranged to control the encoding circuit module (20) to execute handover between the layered operation mode steps and LU decomposition mode steps;

wherein the control circuit module (10) is further arranged to to perform the layered operation mode steps by specifically including steps of determining, a row in the first layer, and determining, according to the column where the element "1" is located in the check-bit matrix part $H_p$, location information of the corresponding check bit of said row in the first layer in the code word of the LDPC code; and determining a row in the second layer, one of the two elements "1" is in the same column as the element "1" of said determined row in the first layer, and determining according to the column where the element "1" that is not in the same column as the element "1" of said determined row in the first layer is located in the check-bit matrix part $H_p$, the location information of the corresponding check bit of said row in the second layer in the code word of the LDPC code; and determining a row in the $i^{th}$ layer, i-1 elements "1" of the i elements "1" are in the same columns as the elements "1" of the first i-1 layers, wherein the value of i is an integer greater than 0, and determining, according to the column where the element "1" that is not in the same columns as the elements "1" of the first i-1 layers is located in the check-bit matrix part $H_p$, the location information of the corresponding check bit of said row in the $i^{th}$ layer in the code word of the LDPC code;

the encoding circuit module (20) is arranged to perform layered operation mode steps which include steps of obtaining, according to the location information and the corresponding row information provided by the control circuit module (10), the value of the check bits corresponding to the location information; and to perform LU decomposition mode steps which include steps of executing LU decomposition to a matrix $H_t$ corresponding to remaining check bits for which no value has been obtained during the layered operation mode steps to obtain values of the remaining check bits; and updating the code word according to the obtained values of the remaining check bits;

wherein the encoding circuit module (20) is further arranged to perform the layered operation mode steps by specifically including to cover the initial values corresponding to the locations of the corresponding check bits of said rows in the first i layers in the code word with the values of the check bits obtained according to the determined location information and the corresponding row information of said rows in the first i layers;

wherein the remaining check matrix $H_t$ is obtained from the check-bit matrix part $H_p$ by removing the rows determined during the layered operation mode steps and the columns containing the element "1" within the rows determined during the layered operation mode steps.

7. The layered encoding device for the LDPC code according to claim 6, wherein the encoding circuit module (20) is further arranged to obtain the values of the check bits respectively through modulo-2 sum operations under the layered operation mode and the LU decomposition mode.

8. The layered encoding device for the LDPC code according to claim 6 or 7, wherein
the encoding circuit module (20) is further arranged to, under the layered operation mode, when a same layer corresponds to multiple rows in the check-bit matrix part $H_p$, execute the modulo-2 sum operations to all rows in parallel.

## Patentansprüche

1. Schichtcodierverfahren für einen Low-Density-Parity-Check-LDPC-Code,
wobei der LDPC-Code systematisch ist und eine Prüfmatrix H des LDPC-Codes in einen Prüfbit-Matrixteil $H_p$ und einen Informationsbit-Matrixteil $H_s$ unterteilt ist,
wobei das Verfahren umfasst:

Initialisieren eines Codeworts des LDPC-Codes, das Schritte des Initialisierens von Informationsbits und Prüfbits des Codeworts des LDPC-Codes beinhaltet;
wobei das Verfahren des Weiteren Schichtbetriebsmodusschritte umfasst, die beinhalten:

a: Ermitteln (S201) von Ortsinformationen der Prüfbits im Codewort des LDPC-Codes und Zeileninformationen in der Prüfmatrix H, die den Ortsinformationen entsprechen, gemäß Strukturcharakteristika des Prüfbit-Matrixteils $H_p$ der Prüfmatrix H, wobei gemäß den Strukturcharakteristika des Prüfbit-Matrixteils $H_p$ die Prüfmatrix H i Schichten, wobei i > 0, umfasst, wobei jede Schicht zumindest eine Zeile der Prüfmatrix H umfasst, wobei jede Zeile der ersten Schicht nur ein Element "1" im Prüfbit-Matrixteil $H_p$ umfasst und jede Zeile der i-ten Schicht, wobei i > 1, nur i Elemente "1" im Prüfbit-Matrixteil $H_p$ enthält, wobei i-1 Elemente "1" der i Elemente "1" in den gleichen Spalten wie die Elemente "1" in den ersten i-1 Schichten sind;
b: Erhalten (S202) von Werten der Prüfbits, die den Ortsinformationen entsprechen, gemäß den ermittelten Ortsinformationen und den entsprechenden Zeileninformationen und Aktualisieren des Codeworts gemäß den erhaltenen Werten der Prüfbits; und

wobei das Verfahren des Weiteren LU-Zerlegungsmodusschritte umfasst, die beinhalten:

c: Durchführen (S203) einer LU-Zerlegung an einer Matrix $H_t$, die restlichen Prüfbits entspricht, für die während der Schichtbetriebsmodusschritte kein Wert erhalten wurde, um Werte der restlichen Prüfbits zu erhalten, und Aktualisieren des Codeworts gemäß den erhaltenen Werten der restlichen Prüfbits; wobei Schritt a im Spezifischen umfasst:

a1: Ermitteln einer Zeile in der ersten Schicht und Ermitteln gemäß der Spalte, wo sich das Element "1" im Prüfbit-Matrixteil $H_p$ befindet, von Ortsinformationen des entsprechenden Prüfbits der Zeile in der ersten Schicht im Codewort des LDPC-Codes

a2: Ermitteln einer Zeile in der zweiten Schicht, wobei eines der zwei Elemente "1" in der gleichen Spalte wie das Element "1" der ermittelten Zeile in der ersten Schicht ist; und Ermitteln gemäß der Spalte, wo das Element "1 ", das nicht in der gleichen Spalte wie das Element "1" der ermittelten Zeile in der ersten Schicht ist, sich im Prüfbit-Matrixteil $H_p$ befindet, der Ortsinformationen des entsprechenden Prüfbits der Zeile in der zweiten Schicht im Codewort des LDPC-Codes;

a3: Ermitteln einer Zeile in der i-ten Schicht, wobei i-1 Elemente "1" der i Elemente "1" in den gleichen Spalten wie die Elemente "1" der ersten i-1 Schichten sind, wobei der Wert i eine ganze Zahl größer 0 ist; und Ermitteln gemäß der Spalte, wo das Element "1", das nicht in den gleichen Spalten wie die Elemente "1" der ersten i-1 Schichten sind, sich im Prüfbit-Matrixteil $H_p$ befindet, der Ortsinformationen des entsprechenden Prüfbits der Zeile in der i-ten Schicht im Codewort des LDPC-Codes;

wobei der Schritt des Aktualisierens des Codeworts gemäß den erhaltenen Werten der Prüfbits von Schritt b im Spezifischen wie folgt ist:

Füllen der Ausgangswerte, die den Orten der entsprechenden Prüfbits der Zeilen in den ersten i Schichten im Codewort entsprechen" mit den Werten der Prüfbits, die gemäß den ermittelten Ortsinformationen und den entsprechenden Zeileninformationen der Zeilen in den ersten i Schichten erhalten wurden; und

wobei die Matrix $H_t$ aus dem Prüfbit-Matrixteil $H_p$ erhalten wird, indem die während der Schichtbetriebsmodusschritte ermittelten Zeilen und die Spalten, die das Element "1" innerhalb der Zeilen enthalten, die während der Schichtbetriebsmodusschritte ermittelt wurden, entfernt werden.

2. Schichtcodierverfahren für den LDPC-Code nach Anspruch 1, wobei der Schritt b des Erhaltens der Werte der Prüfbits, die den Ortsinformationen entsprechen, im Spezifischen wie folgt ist: Durchführen eines Modulo-2-Summierungsvorgangs an jeder Schicht, um wiederum den Wert des Prüfbits zu erhalten, das den ermittelten Ortsinformationen in jeder Schicht entspricht.

3. Schichtcodierverfahren für den LDPC-Code nach Anspruch 2, wobei der Schritt des Durchführens eines Modulo-2-Summierungsvorgangs an jeder Schicht, um wiederum den Wert des Prüfbits zu erhalten, das den ermittelten Ortsinformationen in jeder Schicht entspricht, im Spezifischen wie folgt ist:

für die erste Schicht ein erstes Durchführen eines "AND"-Vorgangs zwischen einem Bit, das dem initialisierten LDPC-Codewort entspricht, und einem Bit, das einer entsprechenden Zeile in der Prüfmatrix H entspricht, und danach Durchführen des Modulo-2-Summierungsvorgangs;

für die zweite Schicht ein erstes Durchführen eines "AND"-Vorgangs zwischen einem Bit, das dem aktualisierten Codewort in der ersten Schicht entspricht, und einem Bit, das einer entsprechenden Zeile in der Prüfmatrix H entspricht, und danach Durchführen des Modulo-2-Summierungsvorgangs;

und wobei der Rest analog abgeleitet werden kann, für die i-te Schicht ein erstes Durchführen eines "AND"-Vorgangs zwischen einem Bit, das dem aktualisierten Codewort in der (i-1)-ten Schicht entspricht, und einem Bit, das einer entsprechenden Zeile in der Prüfmatrix H entspricht, und danach Durchführen eines Modulo-2-Summierungsvorgangs.

4. Schichtcodierverfahren für den LDPC-Code nach Anspruch 3, das des Weiteren umfasst, dass, wenn die i-te Schicht mehreren Zeilen im Prüfbit-Matrixteil $H_p$ entspricht, Modulo-2-Summierungsvorgänge an allen Zeilen parallel durchgeführt werden.

**5.** Schichtcodierverfahren für den LDPC-Code nach Anspruch 4, wobei Schritt c im Spezifischen umfasst: Durchführen eines Modulo-2-Summierungsvorgangs zwischen entsprechenden Bits einer Zeile der Prüfmatrix H, die der Matrix $H_t$ entspricht, und dem in Schritt b aktualisierten Codewort, um einen temporären Wert $X_t$ zu erhalten; und Erhalten des Werts der restlichen Prüfbits gemäß dem temporären Wert $X_t$, der durch Durchführen der LU-Zerlegung und eines rekursiven Vorgangs an der Matrix H zu ermitteln ist.

**6.** Schichtcodiervorrichtung für einen LDPC-Code, wobei der LDPC-Code systematisch ist, und eine Prüfmatrix H des LDPC-Codes in einen Prüfbit-Matrixteil $H_p$ und einen Informationsbit-Matrixteil $H_s$ unterteilt ist, umfassend: ein Steuerschaltkreismodul (10) und ein Codierschaltkreismodul (20),
wobei das Steuerschaltkreismodul (10) so ausgelegt ist, dass es ein Codewort des LDPC-Codes initialisiert, was Schritte des Initialisierens von Informationsbits und Prüfbits des Codeworts des LDPC-Codes beinhaltet; und dass es Schichtbetriebsmodusschritte durchführt, die Schritte des Ermittelns von Ortsinformationen der Prüfbits im Codewort des LDPC-Codes und Zeileninformationen in der Prüfmatrix H, die den Ortsinformationen entsprechen, gemäß Strukturcharakteristika des Prüfbit-Matrixteils $H_p$ der Prüfmatrix H, und des Bereitstellens der ermittelten Ortsinformationen und der entsprechenden Zeileninformationen an das Codierschaltkreismodul (20) beinhalten,
wobei gemäß den Strukturcharakteristika des Prüfbit-Matrixteils $H_p$ die Prüfmatrix H i Schichten, wobei i > 0, umfasst, wobei jede Schicht zumindest eine Zeile der Prüfmatrix H umfasst, wobei jede Zeile der ersten Schicht nur ein Element "1" im Prüfbit-Matrixteil $H_p$ umfasst und jede Zeile der i-ten Schicht, wobei i > 1, nur i Elemente "1" im Prüfbit-Matrixteil $H_p$ enthält, wobei i-1 Elemente "1" der i Elemente "1" in den gleichen Spalten wie die Elemente "1" in den ersten i-1 Schichten sind;
wobei das Steuerschaltkreismodul (10) des Weiteren so ausgelegt ist, dass es das Codierschaltkreismodul (20) so steuert, dass eine Übergabe zwischen den Schichtbetriebsmodusschritten und den LU-Zerlegungsmodusschritten durchführt;
wobei das Steuerschaltkreismodul (10) des Weiteren so ausgelegt ist, dass es die Schichtbetriebsmodusschritte durchführt, im Spezifischen durch Beinhalten von Schritten des Ermittelns einer Zeile in der ersten Schicht und Ermittelns gemäß der Spalte, wo sich das Element "1" im Prüfbit-Matrixteil $H_p$ befindet, von Ortsinformationen des entsprechenden Prüfbits der Zeile in der ersten Schicht im Codewort des LPDC-Codes; und des Ermittelns einer Zeile in der zweiten Schicht, wobei eines der zwei Elemente "1" in der gleichen Spalte wie das Element "1" der ermittelten Zeile in der ersten Schicht ist, und des Ermittelns gemäß der Spalte, wo das Element "1", das nicht in der gleichen Spalte wie das Element "1" der ermittelten Zeile in der ersten Schicht ist, sich im Prüfbit-Matrixteil $H_p$ befindet, der Ortsinformationen des entsprechenden Prüfbits der Zeile in der zweiten Schicht im Codewort des LDPC-Codes; und des Ermittelns einer Zeile in der i-ten Schicht, wobei i-1 Elemente "1" der i Elemente "1" in den gleichen Spalten wie die Elemente "1" der ersten i-1 Schichten sind, wobei der Wert i eine ganze Zahl größer 0 ist, und Ermittelns gemäß der Spalte, wo das Element "1", das nicht in den gleichen Spalten wie die Elemente "1" der ersten i-1 Schichten sind, sich im Prüfbit-Matrixteil $H_p$ befindet, der Ortsinformationen des entsprechenden Prüfbits der Zeile in der i-ten Schicht im Codewort des LDPC-Codes;
wobei das Codierschaltkreismodul (20) so ausgelegt ist, dass es Schichtbetriebsmodusschritte durchführt, die Schritte des Erhaltens des Werts der Prüfbits, die den Ortsinformationen entsprechen, gemäß den Ortsinformationen und den entsprechenden Zeileninformationen, die vom Steuerschaltkreismodul bereitgestellt werden, beinhalten; und dass es LU-Zerlegungsmodusschritte durchführt, die Schritte des Durchführens einer LU-Zerlegung an einer Matrix $H_t$, die den restlichen Prüfbits entspricht, für die während der Schichtbetriebsmodusschritte kein Wert erhalten wurde, um Werte der restlichen Prüfbits zu erhalten; und des Aktualisierens des Codeworts gemäß den erhaltenen Werten der restlichen Prüfbits beinhalten;
wobei das Codierschaltkreismodul (20) des Weiteren so ausgelegt ist, dass es die Schichtbetriebsmodusschritte durchführt, durch im Spezifischen Beinhalten des Füllens der Ausgangswerte, die den Orten der entsprechenden Prüfbits der Zeilen in den ersten i Schichten im Codewort entsprechen, mit den Werten der Prüfbits, die gemäß den ermittelten Ortsinformationen und den entsprechenden Zeileninformationen der Zeilen in den ersten i Schichten erhalten wurden; und
wobei die restliche Prüfmatrix $H_t$ aus dem Prüfbit-Matrixteil $H_p$ erhalten wird, indem die während der Schichtbetriebsmodusschritte ermittelten Zeilen und die Spalten, die das Element "1" innerhalb der Zeilen enthalten, die während der Schichtbetriebsmodusschritte ermittelt wurden, entfernt werden.

**7.** Schichtcodiervorrichtung für den LDPC-Code nach Anspruch 6, wobei das Codierschaltkreismodul (20) des Weiteren so ausgelegt ist, dass es die Werte der Prüfbits jeweils durch Modulo-2-Summierungsvorgänge im Schichtbetriebsmodus und im LU-Zerlegungsmodus erhält.

**8.** Schichtcodiervorrichtung für den LDPC-Code gemäß Anspruch 6 oder 7, wobei das Codierschaltkreismodul (20) des Weiteren so ausgelegt ist, dass es im Schichtbetriebsmodus, wenn eine gleiche Schicht mehreren Zeilen im

Prüfbit-Matrixteil $H_p$ entspricht, die Modulo-2-Summierungsvorgängen an allen Zeilen parallel durchführt.

**Revendications**

1. Procédé de codage en couches pour un code de contrôle de parité à faible densité, LDPC,
dans lequel le code de contrôle LDPC est systématique et une matrice de contrôle H du code de contrôle LDPC est divisée en une partie de matrice de bits de contrôle $H_p$ et une partie de matrice de bits d'information $H_s$,
le procédé comportant l'étape ci-dessous consistant à :

   initialiser un mot de code du code de contrôle LDPC, ce qui inclut des étapes d'initialisation de bits d'information et de bits de contrôle du mot de code du code de contrôle LDPC ;
   le procédé comprenant en outre des étapes de mode d'opération en couches consistant à :

   a : déterminer (S201), selon des caractéristiques de structure de la partie de matrice de bits de contrôle $H_p$ de la matrice de contrôle H, des informations de localisation des bits de contrôle dans le mot de code du code de contrôle LDPC et des informations de rangée dans la matrice de contrôle H correspondant aux informations de localisation, dans lequel, selon les caractéristiques de structure de la partie de matrice de bits de contrôle $H_p$, la matrice de contrôle H comprend i couches où i > 0, chaque couche comprend au moins une rangée de la matrice de contrôle H, chaque rangée de la première couche ne contenant qu'un élément « 1 » dans la partie de matrice de bits de contrôle $H_p$ et chaque rangée de la $i^{ieme}$ couche où i > 1 ne contenant que i éléments « 1 » dans la partie de matrice de bits de contrôle $H_p$ où i - 1 éléments « 1 » desdits i éléments « 1 » sont dans les mêmes colonnes que les éléments « 1 » dans les premières i - 1 couches ;
   b : obtenir (S202), selon les informations de localisation déterminées et les informations de rangée correspondantes, des valeurs des bits de contrôle correspondant aux informations de localisation, et mettre à jour le mot de code selon les valeurs obtenues des bits de contrôle ; et
   le procédé comprenant en outre des étapes de mode de décomposition LU consistant à :

   c : exécuter (S203) une décomposition LU sur une matrice $H_t$ correspondant à des bits de contrôle résiduels pour lesquels aucune valeur n'a été obtenue au cours des étapes de mode d'opération en couches en vue d'obtenir des valeurs des bits de contrôle résiduels, et mettre à jour le mot de code selon les valeurs obtenues des bits de contrôle résiduels ;
   dans lequel l'étape « a » comprend spécifiquement les étapes ci-dessous consistant à :

   a1 : déterminer une rangée dans la première couche, et déterminer, selon la colonne où l'élément « 1 » est situé dans la partie de matrice de bits de contrôle $H_p$, des informations de localisation du bit de contrôle correspondant de ladite rangée dans la première couche dans le mot de code du code de contrôle LDPC ;
   a2 : déterminer une rangée dans la seconde couche, dans lequel l'un des deux éléments « 1 » se situe dans la même colonne que l'élément « 1 » de ladite rangée déterminée dans la première couche ; et déterminer, selon la colonne dans laquelle l'élément « 1 », qui n'est pas dans la même colonne que l'élément « 1 » de ladite rangée déterminée dans la première couche, se situe dans la partie de matrice de bits de contrôle $H_p$, les informations de localisation du bit de contrôle correspondant de ladite rangée dans la seconde couche dans le mot de code du code de contrôle LDPC ;
   a3 : déterminer une rangée dans ladite $i^{ieme}$ couche, dans lequel i - 1 éléments « 1 » des i éléments « 1 » sont dans les mêmes colonnes que les éléments « 1 » des premières i - 1 couches, dans lequel la valeur de i est un nombre entier supérieur à 0 ; et déterminer, selon la colonne dans laquelle l'élément « 1 », qui n'est pas dans les mêmes colonnes que les éléments « 1 » des premières i - 1 couches, se situe dans la partie de matrice de bits de contrôle $H_p$, les informations de localisation du bit de contrôle correspondant de ladite rangée dans ladite $i^{ieme}$ couche dans le mot de code du code de contrôle LDPC ;
   dans lequel l'étape de mise à jour du mot de code selon les valeurs obtenues des bits de contrôle de l'étape b consiste spécifiquement à :

   couvrir les valeurs initiales correspondant aux emplacements des bits de contrôle correspondants desdites rangées dans les premières i couches du mot de code avec les valeurs des bits de contrôle obtenues selon les informations de localisation déterminées et les informations de rangée correspondantes desdites rangées dans les premières i couches ; et

dans lequel la matrice $H_t$ est obtenue à partir de la partie de matrice de bits de contrôle $H_p$, en supprimant les rangées déterminées au cours des étapes de mode d'opération en couches et les colonnes contenant l'élément « 1 » au sein des rangées déterminées au cours des étapes de mode d'opération en couches.

2. Procédé de codage en couches pour le code de contrôle LDPC selon la revendication 1, dans lequel l'étape b consistant à obtenir les valeurs des bits de contrôle correspondant aux informations de localisation consiste spécifiquement à : exécuter une opération de somme modulo 2 sur chaque couche tour à tour en vue d'obtenir la valeur du bit de contrôle correspondant aux informations de localisation déterminées dans chaque couche.

3. Procédé de codage en couches pour le code de contrôle LDPC selon la revendication 2, dans lequel l'étape consistant à exécuter une opération de somme modulo 2 sur chaque couche tour à tour en vue d'obtenir la valeur du bit de contrôle correspondant aux informations de localisation déterminées dans chaque couche consiste spécifiquement à :

pour la première couche, exécuter tout d'abord une opération booléenne « ET » entre un bit correspondant au mot de code de contrôle LDPC initialisé et un bit correspondant à une rangée correspondante dans la matrice de contrôle H, et exécuter ensuite une opération de somme modulo 2 ;

pour la seconde couche, exécuter tout d'abord une opération booléenne « ET » entre un bit correspondant au mot de code mis à jour dans la première couche et un bit correspondant à une rangée correspondante dans la matrice de contrôle H, et exécuter ensuite une opération de somme modulo 2 ; et

dans lequel le reste peut être déduit par analogie, pour ladite $i^{\text{ème}}$ couche, par l'étape consistant à exécuter tout d'abord une opération booléenne « ET » entre un bit correspondant au mot de code mis à jour dans la $(i - 1)^{\text{ème}}$ couche et un bit correspondant à une rangée correspondante dans la matrice de contrôle H, et à exécuter ensuite une opération de somme modulo 2.

4. Procédé de codage en couches pour le code de contrôle LDPC selon la revendication 3, comprenant en outre : lorsque ladite $i^{\text{ème}}$ couche correspond à plusieurs rangées dans la partie de matrice de bits de contrôle $H_p$, des opérations de somme modulo 2 sur toutes les rangées qui sont exécutées en parallèle.

5. Procédé de codage en couches pour le code de contrôle LDPC selon la revendication 4, dans lequel l'étape c consiste spécifiquement à : exécuter une opération de somme modulo 2 entre des bits correspondants d'une rangée de la matrice de contrôle H correspondant à la matrice $H_t$ et le mot de code mis à jour à l'étape b, en vue d'obtenir une valeur temporaire $X_t$ ; et obtenir, selon la valeur temporaire $X_t$, la valeur des bits de contrôle résiduels à déterminer en exécutant l'opération récursive et de décomposition LU sur la matrice $H_t$.

6. Dispositif de codage en couches pour un code de contrôle LDPC, dans lequel dans lequel le code de contrôle LDPC est systématique et une matrice de contrôle H du code de contrôle LDPC est divisée en une partie de matrice de bits de contrôle $H_p$ et une partie de matrice de bits d'information $H_s$, comportant : un module de circuit de commande (10) et un module de circuit de codage (20) ;

dans lequel le module de circuit de commande (10) est agencé de manière à initialiser un mot de code du code de contrôle LDPC, ce qui inclut des étapes d'initialisation de bits d'information et de bits de contrôle du mot de code du code de contrôle LDPC ; et à mettre en oeuvre des étapes de mode d'opération en couches qui incluent des étapes consistant à : déterminer, selon des caractéristiques de structure de la partie de matrice de bits de contrôle $H_p$ de la matrice de contrôle H, des informations de localisation des bits de contrôle dans le mot de code du code de contrôle LDPC et des informations de rangée dans la matrice de contrôle H correspondant aux informations de localisation, et fournir, au module de circuit de codage (20), les informations de localisation déterminées et les informations de rangée correspondantes ;

dans lequel, selon les caractéristiques de structure de la partie de matrice de bits de contrôle $H_p$, la matrice de contrôle H comprend i couches où i > 0, chaque couche comprend au moins une rangée de la matrice de contrôle H, chaque rangée de la première couche ne contenant qu'un élément « 1 » dans la partie de matrice de bits de contrôle $H_p$ et chaque rangée de la $i^{\text{ème}}$ couche où i > 1 ne contenant que i éléments « 1 » dans la partie de matrice de bits de contrôle $H_p$ où i - 1 éléments « 1 » desdits i éléments « 1 » sont dans les mêmes colonnes que les éléments « 1 » dans les premières i - 1 couches ;

dans lequel le module de circuit de commande (10) est en outre agencé de manière à commander au module de circuit de codage (20) d'exécuter un transfert entre les étapes de mode d'opération en couches et les étapes de mode de décomposition LU ;

dans lequel le module de circuit de commande (10) est en outre agencé de manière à mettre en oeuvre les étapes de mode d'opération en couches en incluant spécifiquement des étapes consistant à déterminer une rangée dans la première couche, et à déterminer, selon la colonne où l'élément « 1 » est situé dans la partie de matrice de bits de contrôle $H_p$, des informations de localisation du bit de contrôle correspondant de ladite rangée dans la première couche dans le mot de code du code de contrôle LDPC ; et à déterminer une rangée dans la seconde couche, dans lequel l'un des deux éléments « 1 » se situe dans la même colonne que l'élément « 1 » de ladite rangée déterminée dans la première couche, et à déterminer, selon la colonne dans laquelle l'élément « 1 », qui n'est pas dans la même colonne que l'élément « 1 » de ladite rangée déterminée dans la première couche, se situe dans la partie de matrice de bits de contrôle $H_p$, les informations de localisation du bit de contrôle correspondant de ladite rangée dans la seconde couche dans le mot de code du code de contrôle LDPC ; et à déterminer une rangée dans ladite $i^{ième}$ couche, dans lequel i - 1 éléments « 1 » des i éléments « 1 » sont dans les mêmes colonnes que les éléments « 1 » des premières i - 1 couches, dans lequel la valeur de i est un nombre entier supérieur à 0, et déterminer, selon la colonne dans laquelle l'élément « 1 », qui n'est pas dans les mêmes colonnes que les éléments « 1 » des premières i - 1 couches, se situe dans la partie de matrice de bits de contrôle $H_p$, les informations de localisation du bit de contrôle correspondant de ladite rangée dans ladite $i^{ième}$ couche dans le mot de code du code de contrôle LDPC ;

dans lequel le module de circuit de codage (20) est agencé de manière à mettre en oeuvre des étapes de mode d'opération en couches qui incluent des étapes consistant à obtenir, selon les informations de localisation et les informations de rangée correspondantes fournies par le module de circuit de commande (10), la valeur des bits de contrôle correspondant aux informations de localisation ; et à mettre en oeuvre des étapes de mode de décomposition LU qui incluent des étapes consistant à exécuter une décomposition LU sur une matrice $H_t$ correspondant à des bits de contrôle résiduels pour lesquels aucune valeur n'a été obtenue au cours des étapes de mode d'opération en couches en vue d'obtenir des valeurs des bits de contrôle résiduels ; et à mettre à jour le mot de code selon les valeurs obtenues des bits de contrôle résiduels ;

dans lequel le module de circuit de codage (20) est en outre agencé de manière à mettre en oeuvre des étapes de mode d'opération en couches incluant spécifiquement l'étape consistant à couvrir les valeurs initiales correspondant aux emplacements des bits de contrôle correspondants desdites rangées dans les premières i couches du mot de code avec les valeurs des bits de contrôle obtenues selon les informations de localisation déterminées et les informations de rangée correspondantes desdites rangées dans les premières i couches ; et

dans lequel la matrice $H_t$ est obtenue à partir de la partie de matrice de bits de contrôle $H_p$, en supprimant les rangées déterminées au cours des étapes de mode d'opération en couches et les colonnes contenant l'élément « 1 » au sein des rangées déterminées au cours des étapes de mode d'opération en couches.

7. Dispositif de codage en couches pour le code de contrôle LDPC selon la revendication 6, dans lequel le module de circuit de codage (20) est en outre agencé de manière à obtenir les valeurs des bits de contrôle respectivement par le biais d'opérations de somme modulo 2 dans le cadre du mode d'opération en couches et du mode de décomposition LU.

8. Dispositif de codage en couches pour le code de contrôle LDPC selon la revendication 6 ou 7, dans lequel le module de circuit de codage (20) est en outre agencé de manière à, dans le cadre du mode d'opération en couches, lorsqu'une même couche correspond à plusieurs rangées dans la partie de matrice de bits de contrôle $H_p$, exécuter les opérations de somme modulo 2 sur toutes les rangées en parallèle.

Fig. 1

$$X_s \longrightarrow \bigotimes \longrightarrow \boxed{Ly = PH_sX_s} \xrightarrow{\text{Recursion}} \boxed{y = UQ^TX_p} \xrightarrow{\text{Recursion}} \boxed{Q^TX_p} \xrightarrow{\substack{\text{Row} \\ \text{switching}}} X_p$$

$$PH_s$$

Fig. 2

| Determining, according to the structure characteristics of a check-bit matrix part of a check matrix H, location information of a check bit corresponding to a layered operation mode in a code word of an LDPC code and information of a row in H corresponding to the location information. |
|---|

— 201

| Directly obtaining, according to the determined location information and the corresponding row information, the value of the check bit corresponding to the location information by using the layered operation mode, and updating the code word according to the obtained value of the check bit. |
|---|

— 202

| Executing LU decomposition to a remaining check matrix corresponding to a remaining check bit to be determined to obtain the value of the remaining check bit to be determined, and updating the code word according to the obtained value of the check bit. |
|---|

— 203

Fig. 3

| Control circuit module |
|---|

— 10

| Coding circuit module |
|---|

— 20

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 1443656 A2